# EUROPEAN PATENT APPLICATION

(11) **EP 2 514 521 A1**
(43) Date of publication of application: **24.10.2012**
(21) Application number: 11184338.9
(22) Date of filing: 07.10.2011
(51) Int. Cl.: B01J 19/00, B01J 19/24, C01B 33/027

(54) **Polycrystal silicon manufacturing apparatus**

(30) Priority: 20.04.2011 KR 20110036722
(71) Applicant: Silicon Value LLC, Daejon 305-804 (KR)
(72) Inventor: Jung, Yunsub, 157-010 SEOUL (KR); Kim, Keunho, 680-010 ULSAN (KR); Yoon, Yeokyun, 305-770 DAEJEON (KR); Kim, Ted, 302-120 DAEJEON (KR)
(74) Representative: Colombo, Michel

(57) **Abstract**

A polycrystal silicon manufacturing apparatus is disclosed. The polycrystal silicon manufacturing apparatus includes a reaction pipe in which silicon deposition reaction is generated; a flowing-gas supply unit configured to supply flowing gas to silicon particles provided in the reaction pipe; and means configured to maintain a reaction temperature during the silicon deposition reaction generated in the reaction pipe.

## Description

### BACKGROUND

### 1. Field

Embodiments may relate to a polycrystal silicon manufacturing apparatus.

### 2. Background

Generally, high purity polycrystal silicon has been consumed broadly for a semiconductor element that is useable for a semiconductor device or a solar cell, a chemical material that requires a high purity or an industrial element. Also, the high purity polycrystal silicon has be utilized for a precision functioned device or a precision part of a highly integrated micro system.

To fabricate such polycrystal silicon, silicon deposition has been used. According to the silicon deposition, silicon contained in reaction gas is constantly deposited by pyrolysis of reaction gas and hydrogen reaction.

For commercial mass production of the polycrystal silicon, a bell type reactor or a polycrystal silicon manufacturing apparatus have been used. However, the bell type reactor has limitation of a diameter of a rod that increases by the silicon deposition and it has a basic limitation of failure in constant production. The fluidized bed reactor having a high reaction yield under the same reaction condition, compared with the bell type reactor has been getting popular.

However, unless the temperature of a reaction area inside a reaction pipe is maintained uniformly, the fluidized bed reactor also fails to enable stable silicon deposition reaction generated in a surface of a seed crystal constantly and breakage of internal devices provided therein or damage of products might occur disadvantageously.

As a result, demands for a method of enhancing productivity and manufacturing polycrystal silicon particles constantly and stably have been increased.

### SUMMARY

Accordingly, the embodiments may be directed toa polycrystal silicon manufacturing apparatus. An object of the embodiments is to provide a polycrystal silicon manufacturing apparatus which is able to manufacture polycrystal silicon serially and stably.

Another object of the embodiments is to provide a polycrystal silicon manufacturing apparatus having enhanced productivity and a reduced production price.

To achieve these objects and other advantages and in accordance with the purpose of the embodiments, as embodied and broadly described herein, a polycrystal silicon manufacturing apparatus includes a reaction pipe in which silicon deposition reaction is generated; a flowing-gas supply unit configured to supply flowing gas to silicon particles provided in the reaction pipe; and means configured to maintain a reaction temperature during the silicon deposition reaction generated in the reaction pipe.

The means may be provided in the reaction pipe.

The polycrystal silicon manufacturing apparatus may further include a temperature measurement unit configured to measure the reaction temperature, wherein the means may maintain the reaction temperature, based on the reaction temperature value measured by the temperature measurement unit.

The polycrystal silicon manufacturing apparatus may further include a temperature measurement unit configured to detect temperature change inside the reaction pipe.

The temperature measurement unit may include a temperature measuring device; a housing configured to cover the temperature measuring device; and a protection pipe configured to cover the housing, spaced apart a predetermined distance from the housing.

The single temperature measuring device may be installed in the housing or the plurality of the temperature measuring devices may be installed in the housing.

The temperature measuring device may be arranged corresponding to an area where the highest temperature of the heater is measured.

The temperature measurement unit may include a temperature sensor arranged on an outer surface of the reaction pipe.

The plurality of the temperature sensors may be arranged on the outer surface of the reaction pipe, spaced apart a predetermined distance from each other.

An average temperature value of the temperatures measured by the plurality of the temperature sensors may be calculated and the temperature inside the reaction pipe is increased by using the power supply unit, when the average temperature value is smaller than a preset reference temperature value.

The temperature inside the reaction pipe may be increased by using the power supply unit, when a maximum temperature value of the temperatures measured by the plurality of the temperature sensors is smaller than a preset reference temperature value.

The polycrystal silicon manufacturing apparatus may further include a bottom part having the flowing-gas supply unit assembled thereto, wherein the bottom part may include a lower plate; a first plate located on the lower plate, to insulate the lower plate; a second plate located on the first plate, to supply electricity to the heater; and a third plate located on the second plate, to insulate the second plate.

An end of the second plate may be spaced apart a predetermined distance from a surface of the lower plate.

A predetermined portion of the first plate may be located between the lower plate and an end of the second plate.

Each of the second and third plates may include a plurality of unit-plates.

As a result, the polycrystal silicon manufacturing apparatus according to the embodiments may maintain a reaction temperature uniformly. Because of that, polycrystal silicon may be produced stably without damage.

Furthermore, according to the embodiments, damage to internal devices may be prevented by increasing the reaction temperature.

A still further, according to the embodiments, the reaction temperature may be maintained uniformly and serial operation of the polycrystal silicon manufacturing apparatus may be enabled. Because of that, it is possible to mass-produce the polycrystal silicon.

It is to be understood that both the foregoing general description and the following detailed description of the embodiments or arrangements are exemplary and explanatory and are intended to provide further explanation of the embodiments as claimed.

### BRIEF DESCRIPTION OF THE DRAWINGS

Arrangements and embodiments may be described in detail with reference to the following drawings in which like reference numerals refer to like elements and wherein:

FIG. 1 is a diagram schematically illustrating a polycrystal silicon manufacturing apparatus according to an exemplary embodiment;

FIG. 2 is a diagram illustrating an example of a plate provided in polycrystal silicon manufacturing apparatus according to the embodiment;

FIG. 3 is a diagram illustrating another example of the plate provided in the polycrystal silicon manufacturing apparatus according to the embodiment;

FIG. 4 is a diagram illustrating a method of controlling a reaction temperature based on the temperature inside the polycrystal silicon manufacturing apparatus according to the embodiment, FIG. 5 is a diagram illustrating an assembly structure of the flowing-gas supply unit provided in the polycrystal silicon manufacturing apparatus according to the embodiment; and

FIG. 5 is a diagram illustrating a temperature measuring unit according to an embodiment of the present invention.

### DETAILED DESCRIPTION

Reference may now be made in detail to specific embodiments, examples of which may be illustrated in the accompanying drawings. Wherever possible, same reference numbers may be used throughout the drawings to refer to the same or like parts.

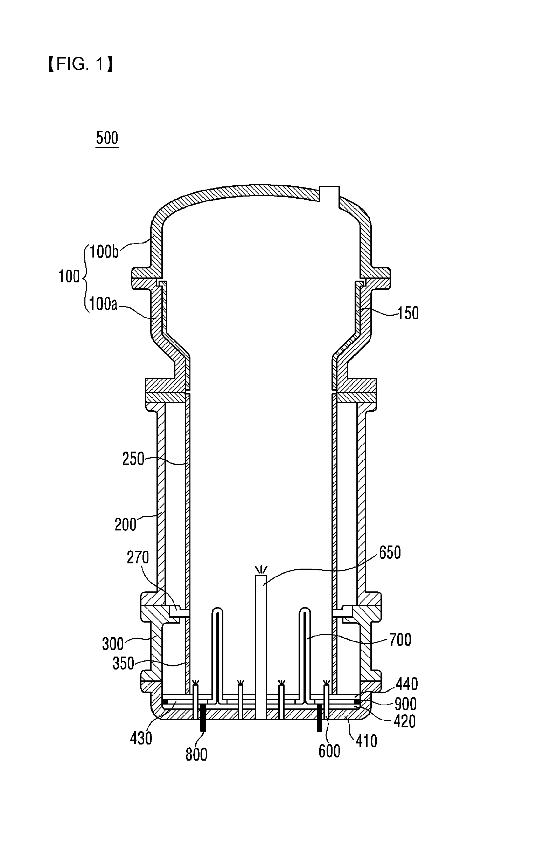

FIG. 1 illustrates a polycrystal silicon manufacturing apparatus according to an exemplary embodiment. As shown in FIG. 1, a polycrystal silicon manufacturing apparatus 500 according to an exemplary embodiment may include a head 100, a first body part 200, a second body part 300 and a bottom part 400.

The head 100 may be connected with the first body part 200 and it may have a larger diameter than a diameter of a first reaction pipe 250 provided in the first body part 200. When gas and microelements within the polycrystal silicon apparatus 500 pass the head 100 from the first reaction pipe 250, the velocity of gas and microelements may decrease because of the larger diameter possessed by the head 100.

As a result, load of a post-process for the exhausted gas or microelements may be reduced. An inner wall of the head 100 may be formed of an inorganic material that will not be transformed at a high temperature. For example, the inner wall of the head 100 may be formed of at least one of quartz, silica, silicon nitride, boron nitride, zirconia, silicon carbide, graphite, silicon and vitreous carbon.

Also, at least one of coating or lining that uses an organic polymer may be performed to the inner wall of the head 100, if it is possible to cool an outer wall of the head 100.

When the inner wall of the head 100 is formed of a carbon containing material such as silicon carbide, graphite and vitreous carbon, polycrystal silicon may be contaminated by carbon impurities. Because of that, silicon, silica, quartz or silicon nitride may be coated or lined on the inner wall of the head 100 which could contact with the polyscrystal silicon.

For example, the head 100 may include a plurality of heads 100a and 100b. A lining layer 150 may be located on an inner surface of the fist head 1 00a.

The first body part 200 may be located under the head 100, connected with the head 100, and it may provide a predetermined space where polycrystal silicon deposition reaction may occur.

The second body part 300 may be located under the first body part 200, with connected with the first body part 200. Together with the first body part 200, the second body part 300 may provide a predetermined space where at least one of polycrystal silicon deposition reaction or heating reaction may occur.

Those first and second body parts 200 and 300 may be independently provided and they may be coupled to each other to provide a reaction space. Alternatively, the first and second body parts 200 and 300 may be integrally formed with each other.

The bottom part 400 may be located under the second body part 300, with connected with the second body part 300. A variety of nozzles 600 and 650, a heater 700 and an electrode 800 may be coupled to the bottom part 400 for the polycrystal silicon deposition. In the meanwhile, the head 100, the first body part 200 and the second body part 300 may be formed of a proper metal material that is easy to treat with good mechanical strength and rigidity such as carbon steel, stainless steel and various steel alloys. A protection layer for the first and second body parts 200 and 300 formed of the material mentioned above may be formed of metal, organic polymer, ceramic or quartz.

When assembling the head 100, the first body part 200 and the second body part 300 to each other, a gasket or a sealing material may be used to shut off the inside of the reactor from external space. Each of the first and second body parts 200 and 300 may have a variety of shapes including a cylindrical pipe, a flange, a tube, a fitting, a plate, a corn, an oval or a jacket having a cooling medium flowing between double-framed walls,

Also, when the head 100, the first body part 200 and the second body part 300 are formed of the metal material, a protection layer may be coated on an inner surface possessed by each of them or a protection pipe or a protection wall may be installed additionally. The protection layer, pipe or wall may be formed of a metal material. However, a non-metal material such as organic polymer, ceramic and quartz may be coated or lined on the protection layer, pipe or wall to prevent contamination inside the reactor.

The first and second body parts 200 and 300 may be maintained blow a predetermined range of temperatures by cooling fluid such as water, oil, gas and air, to prevent heat expansion, to protect workers and to prevent accidents. Inner or outer walls of components provided in the first and second body parts 200 and 300 that need cooling may be fabricated to allow the cooling fluid to circulate there through.

In the meanwhile, an insulator may be arranged on an outer surface of each of the first and second body parts 200 and 300 to protect workers and to prevent too much heat loss.

As follows, a process of assembling a polycrystal silicon manufacturing apparatus according to an embodiment will be described.

A first reaction pipe 250 may be assembled to be located inside the first body part 200 and a second reaction pipe 350 may be assembled to be located inside the second body part 300. Various nozzles 600 and 650, an electrode 800 and a heater 700 are assembled to the bottom part 400 configured to close a bottom of the second body part 300 airtight. The bottom part 400 may be connected with a lower area of the second body part 300 having the second reaction pipe 350 provided therein. After that, the first body part 200 and the second body part 300 may be connected with each other and the head 100 may be connected with the first body part 200.

Various gas supply units assembled to the bottom part 400 may include a flowing-gas supply unit 600 and a reaction gas supply unit 650.

The first and second reaction pipes 250 and 350 may be tube-shaped or partially tube-shaped, corn-shaped and oval-shaped. Each end of the first and second reaction pipes 250 and 350 may be processed to be a flange type. The first and second reaction pipes 250 and 350 may be configured of a plurality of parts and some of the parts may be arranged on inner walls of the first and second body parts 200 and 300 as liners.

The first and second reaction pipes 250 and 350 may be formed of an inorganic material that is not transformed easily at a high temperature. The inorganic material may be quartz, silica, silicon nitride, boron nitride, zirconia, yttria, silicon carbide, graphite, silicon, vitreous carbon and a compound of them.

When the first and second reaction pipes 250 and 350 are formed of a carbon containing material such as silicon carbide, graphite, vitreous carbon and the like, the carbon containing material might contaminate the polycrystal silicon. Because of that, silicon, silica, quartz, silicon nitride and the like may be coated or lined on each inner wall of the first and second reaction pipes that can contact with the polycrystal silicon.

The flowing-gas supply unit 600 may be configured to supply flowing-gas that enables silicon particles to flow within the reaction pipe. Some or all of the silicon particles may flow with the flowing-gas. At this time, the flowing-gas may include at least one of hydrogen, nitrogen, argon, helium, hydrogen chloride (HCl), silicon tetra chloride (SiCl₄). The flowing-gas supply unit 600 may be a tub, a liner or a molded material.

The reaction gas supply unit 650 may be configured to supply reaction gas that containing silicon elements to a silicon particle layer. The reaction gas is raw material gas that is used in deposition of polycrystal silicon and it may include silicon elements. The reaction gas may include at least one of monosilan (SiH₄), disilane (Si₆H₆), higher-silane (SiₙH₂ₙ₊₂, 'n' is a 3 or more a natural number), dichlide silane (SCS: SiH₂C1₂), trichlide silane (TCS: SiHCl₃), tetra chlide silane (STC: SiCl₄), dibromosilane (SiH₂Br₂), tribromo silane (SiHBr₃), silicontetrabromide (SiBr₄), diiodosilane (SiH₂l₂), triiodosilane (SiHl₃) and silicontetraiodide (Sil₄). At this time, the reaction gas may further include at least one of hydrogen, nitrogen, argon, helium or hydrogen chloride. As the reaction gas is supplied, polycrystal silicon is deposited on a surface of a seed crystal having a size of 0.1 to 2mm and the size of the polycrystal silicon may be increased.

When the size of the polycrystal silicon is increased up to a preset value, the reaction gas may be exhausted outside the polycrystal silicon manufacturing apparatus. The heater 700 may supply heat that is used for generating silicon deposition reaction on the surface of the polycrysal silicon within the polycrystal silicon manufacturing apparatus.

According to the embodiment, the heat used for the silicon deposition reaction may be generated in the reaction pipe. Alternatively, the heat generated outside the reaction pipe 250 may be supplied to the inside of the reaction pipe 250 and the heat may be used for the silicon deposition reaction. The heater 700 may include a resistant to be supplied electricity, to generate and supply the heat. The heater 700 may include at least one of graphite, ceramic such as and a metal material.

A gas outlet may be arranged in the head 100 to exhaust exhaustion gas including the flowing gas, non-reaction gas, reaction generation gas outside. Here, the gas outlet may be operated serially. Minute silicon particles or high molecular reaction by-product transported by the exhaustion gas may be separated in an auxiliary exhaustion processing unit (not shown).

The gas supply units 600 and 650, that is, various nozzles, the electrode 800 and the heater 700 may be assembled to the bottom part 400, together with plates 410 to 440 composing the bottom part 400.

At this time, the electrode 800 may be electrically connected with the heater 700 and the heater 700 may be heated by an electric voltage supplied from the electrode 800.

As shown in the drawings, the bottom part 400 according to the embodiment may include a lower plate 410 and first to third plates 420, 430 and 440.

The lower plate 410 may be connected with the second body part 300 and it may be assembled to the flowing-gas supply unit and the reaction gas supply unit. The lower plate 410 may be formed of a metal material that is easy and efficient to process, with an excellent mechanical strength and rigidity, such as carbon steel, stainless steel and alloy steel.

The first plate 420 may be located on the lower plate 410, to insulate the lower plate 410. Because of that, the first plate 420 may be formed of a proper material that may be resistant against a high temperature, without contaminating the deposited polycrystal silicon and even with an insulation property, such as quartz. The first plate 420 may be formed of a ceramic material such as silicon nitride, alumina and yttria, rather than quartz. If necessary, such a ceramic material may be coated or lined on a surface of the first plate 420.

The second plate 430 may be located on the first plate 420 and it may be in contact with the heater 700 to supply electricity to the heater 700. Because of that, the second plate 430 may be formed of a conductive material such as graphite, graphite having silicon carbide coated thereon, silicon carbide and graphite having silicon nitride coated thereon. The first plate 420 having the insulation property may be located between the lower plate 410 and the second plate 430, such that the lower plate 410 may be insulated from the second plate 430. The second plate 430 may be in contact with the heater 700 and heat may be generated from the second plate 430. However, the second plate 430 may have a relatively large sectional area where electric currents flow, compared with a sectional area of the heater where electric currents flow. Because of that, the heat generated in the second plate 430 may be much smaller than the heat generated in the heater 700. Also, to reduce the heat generated in the second plate 430, a graphite sheet may be insertedly disposed between the second plate 430 and the heater 700.

When the lower plate 410 and the second plate 430 have conductivity, a leakage current might be generated by the contact between the lower plate 410 and the second plate 430 and the leakage current might flow to the lower plate 410. Because of that, an end of the lower plate 410 may be spaced apart a proper distance from an end of the second plate 430 as shown in the drawings.

In other words, a recess may be formed in the first plate 420 and the second plate 430 may be seated in the recess. For example, a recess having an identical to or larger length as the length of the second plate 430 may be formed in the first plate 420 and the second plate may be seated in the recess of the first plate 420. As a result, a proper area of the first plate 420 may be positioned between the lower plate 410 and the end of the second plate 430, to maintain the insulation between the lower plate 410 and the second plate 430.

As shown in the drawings, the lower plate 410 and the second plate 430 may be insulated from each other by the first plate 420. Alternatively, an insulation ring 900 may be arranged around a rim of the second plate 430, to insulate the lower plate 410 from the second plate 430. At this time, the insulation ring 900 may be formed of quartz and ceramic.

The third plate 440 may be located on the second plate 430 to prevent the polycrystal silicon deposited from the first and second reaction pipes 250 and 350 from being contaminated from the second plate 430, with an insulation property. Because of that, the third plate 440 may be formed of an inorganic material that may not be transformed at a high temperature, namely, high-temperature-resist. The inorganic material may be quartz, silica, silicon nitride, boron nitride, zirconia, silicon carbide, graphite, silicon, vitreous carbide or a compound of them. When the third plate 440 is formed of the carbon containing material such as silicon carbide, graphite and vitreous carbon, the carbon containing material might contaminate the polycrystal silicon. Silicon, silica, quartz, silicon nitride and the like may be coated or lined on a surface of the third plate 440.

Also, each of the second plate and the third plates 440 composing the bottom part 400 may include a plurality of unit-plates, not as a single body. Because of that, the assembly, installation and maintenance of the polycrystal silicon manufacturing apparatus may be more smooth and efficient. In other words, the size of the polycrystal silicon manufacturing apparatus is increased for the mass production of polycrystal silicon. When each of the second and third plates 430 and 440 is formed as a single body, the assembly, installation and maintenance of the polycrystal silicon manufacturing apparatus may be difficult.

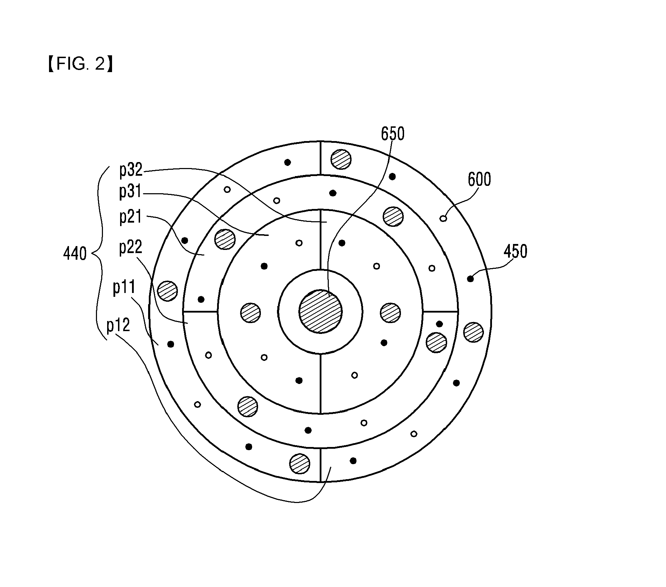

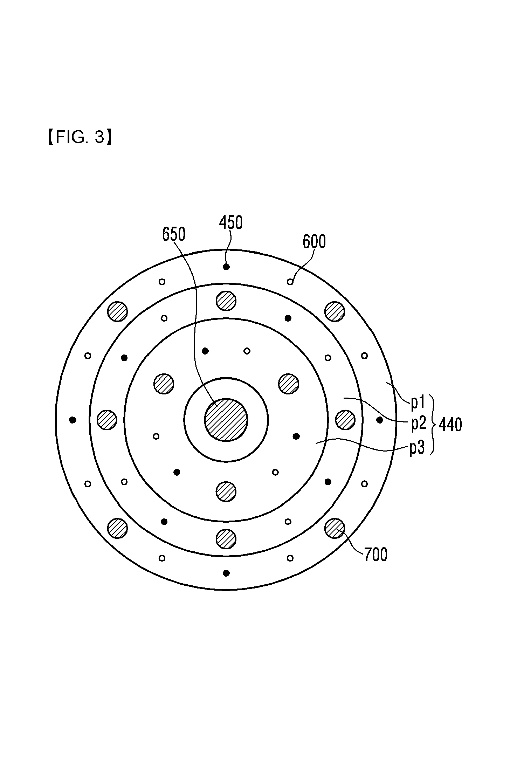

For example, as shown in FIG. 2, the third plate 440 may be configured of pieces cut away along concentric and diameter directions with respect to the third plate 440. As shown in FIG. 3, the third plate 440 may be configured of ring-shaped pieces having different sizes.

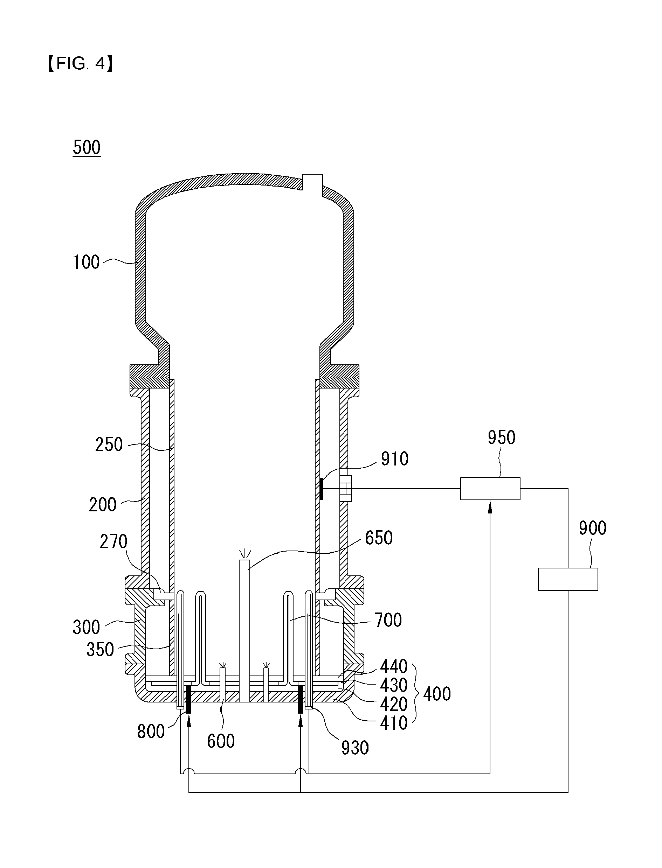

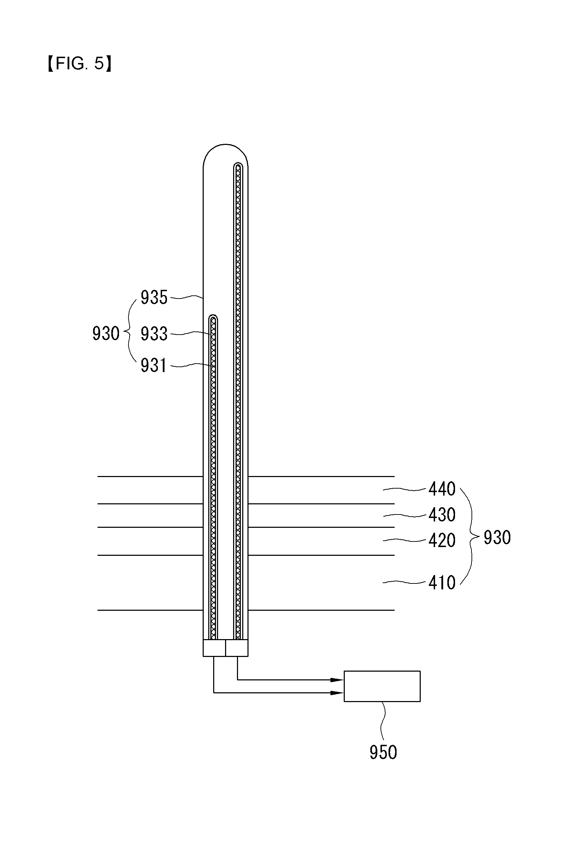

FIG. 4 is a diagram illustrating a method of controlling a reaction temperature based on a temperature inside the polycrystal silicon manufacturing device according to the embodiment. FIG. 5 is a diagram illustrating a temperature measurement unit according an embodiment.

In reference to FIGS. 4 and 5, the same description as already described above in the structure of the polycrystal silicon manufacturing apparatus in reference to FIG. 1 will be omitted. The polycrystal silicon manufacturing apparatus 500 may include a temperature measurement unit 910 and 930, a control unit 950 and a power supply unit 900.

The temperature measurement unit 910 and 930 may periodically measure the temperature inside the reaction pipes 250 and 350 in which the silicon deposition reaction may occur or it may serially measure the temperatures while the silicon deposition reaction is generated.

Such the temperature measurement unit 910 and 930 may be arranged on an outer surface of the reaction pipe to measure the temperature inside the reaction pipe or they may be arranged in the lower part 400, located toward the internal space of the reaction pipe.

When it is arranged on the outer surface of the reaction pipe, the temperature measurement unit may include a temperature sensor 910 or it may be a temperature sensor itself, to measure the temperature inside the reaction pipe at the outer surface of the reaction pipe. When the reaction temperature inside the reaction pipe is measured at the outer surface of the reaction pipe by using the temperature sensor 910, the flow of particles inside the reaction pipe may not be interfered with and productivity or reaction conditions may not be interfered with accordingly.

At least one temperature sensor 910 may be provided. When the plurality of the temperature sensors are provided, the plurality of the temperature sensors may be arranged on outer surfaces of two reaction pipes at a proper distance.

At this time, the plurality of the temperature sensors may measure the temperature inside an internal space of the reaction pipe, located at areas they are arranged on. The control unit 950 may detect a maximum value out of the measured temperature value and it may compare the maximum value with a preset reference value. When the maximum value is smaller than the reference value, the control unit 950 may control the power supply unit 900 to increase the temperature inside the reaction pipe, to maintain the reaction temperature uniformly.

The control of the power supply unit 900 performed by the control unit 950 may include control of electric voltages or currents. Because of that, an element transmitted to the heater to maintain the temperature inside the reaction pipe may be an electric voltage or an electric current.

The reference temperature value may not be a fixed value and it may be a temperature value required to enable the reaction generated in the polycrystal silicon manufacturing apparatus serially and stably. Because of that, the reference value may be set differently based on an internal environment or a structure of the polycrystal silicon manufacturing apparatus.

Also, when the plurality of the temperature sensors measure the temperature inside the internal area of the reaction pipe at corresponding areas they are located, the control unit 950 may calculate an average temperature value of the measured temperatures and it may compare the average temperature value with the preset reference temperature value. When the average temperature value is smaller than the reference value, the control unit 950 may control the power supply unit 900 to increase the temperature inside the reaction pipe to maintain it uniformly.

When the temperature measurement unit 930 is assembled to the lower part 400, arranged toward the internal space of the reaction pipe, there may be interference with the flow of particles inside the reaction pipe, compared with when the temperature measurement unit is arranged on the outer surface of the reaction pipe. However, the reaction temperature may be directly measured in the reaction pipe and an error of the temperature measurement generated by overheat of the heater may be decreased in the silicon deposition reaction.

The temperature measurement 930 may be arranged in parallel to the heater 700 to reduce the interference with the flow of the particles inside the reaction pipe. Because of that, the assembly and installation of the bottom part 400 may be smooth advantageously.

The temperature measurement unit 930 may include a temperature measuring device 931, a housing 933 configured to surround the temperature measuring device 931 and a protection pipe 935 configured to surround the housing to prevent, spaced apart a predetermined distance from the housing to prevent contamination that might be generated by physical or chemical reaction. The protection pipe could be damaged by a difference between the pressure of the reaction pipe and that of the protection pipe. Because of that, proper gas may be supplied to a space formed between the housing and the protection pipe to reduce the pressure difference between the reaction pipe and the protection pipe, only to prevent damage to the protection pipe.

The temperature measuring device 931 may be a thermocouple or pyrometer. When the pyrometer is used as the temperature measuring device 931, the pyrometer may be installed to nozzles having windows installed therein provided in the head 100 or the body parts 200 and 300 composing the polycrystal silicon manufacturing apparatus, without the housing or the protection pipe, to measure the temperature inside the reaction pipe. At this time, the windows may be formed of a transparent material, for example, quarts and tempered glass. If necessary, gold (Au) or barium (Ba) may be coated on the windows.

At least one temperature measuring unit 930 may be assembled to the bottom part 400, toward the internal space of the reaction pipe. A single housing 933 may be provided in a single temperature measurement unit or a plurality of housings may be provided in the single temperature measurement unit.

At this time, a single temperature measuring device 931 or a plurality of temperature measuring devices 931 may be mounted in the housing 933. When the single temperature measuring device is provided in the housing 933, the temperature measuring device 931 may be mounted at an area corresponding to the area that is proper to measure the highest temperature of the heater. To maintain the temperature inside the reaction pipe uniformly by controlling the power supply unit 900 based on the temperature inside the reaction pipe, accuracy of the temperature measurement inside the reaction pipe has to be enhanced and the control of the power supply unit 900 may be performed smoothly and efficiency because of the enhanced accuracy of the temperature measurement.

When the plurality of the temperature measuring devices 931 are provided, the plurality of the temperature measuring devices 931 may be mounted corresponding to the area where the highest temperature of the heater may be measured and corresponding to areas where temperatures of neighboring areas may be measured. At this time, the control unit 950 may calculate an average value of the temperatures measured in the plurality of the areas and it may compare the average temperature value with a preset reference value, to control the power supply unit 900 based on the result of the comparison.

As described above, the polycrystal silicon manufacturing apparatus may maintain the temperature inside the reaction pipe uniformly according to temperature change inside the reaction pipe, while the silicon deposition reaction is generated in the reaction pipe. Because of that, the polycrystal silicon manufacturing apparatus may be operated serially and the mass production of the polycrystal silicon may be possible.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to affect such feature, structure, or characteristic in connection with other ones of the embodiments. Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A polycrystal silicon manufacturing apparatus comprising:
a reaction pipe in which silicon deposition reaction is generated;
a flowing-gas supply unit configured to supply flowing gas to silicon particles provided in the reaction pipe; and
means configured to maintain a reaction temperature during the silicon deposition reaction generated in the reaction pipe.

2. The polycrystal silicon manufacturing apparatus as claimed in claim 1, wherein the means comprises,
a heater configured to supply heat to an internal space of the reaction pipe to generate silicon deposition reaction of the silicon particles;
a power supply unit configured to supply electricity to the heater; and
a control unit configured to control the power supply unit to maintain the temperature inside the reaction pipe uniformly during the silicon deposition reaction inside the reaction pipe.

3. The polycrystal silicon manufacturing apparatus as claimed in claim 2, wherein the control unit controls the power supply unit, when the temperature inside the reaction pipe is changed.

4. The polycrystal silicon manufacturing apparatus as claimed in one of claims 1 to 3, further comprising:
a temperature measurement unit configured to detect temperature change inside the reaction pipe.

5. The polycrystal silicon manufacturing apparatus as claimed in claim 4, wherein the temperature measurement unit comprises,
a temperature measuring device;
a housing configured to cover the temperature measuring device; and
a protection pipe configured to cover the housing, spaced apart a predetermined distance from the housing.

6. The polycrystal silicon manufacturing apparatus as claimed in claim 5, wherein the single temperature measuring device is installed in the housing or the plurality of the temperature measuring devices are installed in the housing.

7. The polycrystal silicon manufacturing apparatus as claimed in claim 5 or 6, wherein the temperature measuring device is arranged corresponding to an area where the highest temperature of the heater is measured.

8. The polycrystal silicon manufacturing apparatus as claimed in claim 4 or 5, wherein the temperature measurement unit comprises a temperature sensor arranged on an outer surface of the reaction pipe.

9. The polycrystal silicon manufacturing apparatus as claimed in claim 8, wherein the plurality of the temperature sensors are arranged on the outer surface of the reaction pipe, spaced apart a predetermined distance from each other.

10. The polycrystal silicon manufacturing apparatus as claimed in claim 9, wherein an average temperature value of the temperatures measured by the plurality of the temperature sensors is calculated and the temperature inside the reaction pipe is increased by using the power supply unit, when the average temperature value is smaller than a preset reference temperature value.

11. The polycrystal silicon manufacturing apparatus of claim 9, wherein the temperature inside the reaction pipe is increased by using the power supply unit, when a maximum temperature value of the temperatures measured by the plurality of the temperature sensors is smaller than a preset reference temperature value.

12. The polycrystal silicon manufacturing apparatus as claimed in claim 1, further comprising:
a bottom part having the flowing-gas supply unit assembled thereto,
wherein the bottom part comprises,
a lower plate; a first plate located on the lower plate, to insulate the lower plate;
a second plate located on the first plate, to supply electricity to the heater; and
a third plate located on the second plate, to insulate the second plate.

13. The polycrystal silicon manufacturing apparatus as claimed in claim 12, wherein an end of the second plate is spaced apart a predetermined distance from a surface of the lower plate.

14. The polycrystal silicon manufacturing apparatus as claimed in claim 12, wherein a predetermined portion of the first plate is located between the lower plate and an end of the second plate.

15. The polycrystal silicon manufacturing apparatus as claimed in claim 12, wherein each of the second and third plates comprises a plurality of unit-plates.
